# EUROPÄISCHE PATENTANMELDUNG

(11) **EP 3 648 297 A1**
(43) Veröffentlichungstag der Anmeldung: **06.05.2020**
(21) Anmeldenummer: 18203156.7
(22) Anmeldetag: 29.10.2018
(51) Int. Cl.: H02J 13/00, G01R 19/175

(54) **VERFAHREN UND VORRICHTUNG ZUR BEREITSTELLUNG EINER PHASENINFORMATION EINES VERSORGUNGSNETZES**

(71) Anmelder: Siemens Aktiengesellschaft, 80333 München (DE)
(72) Erfinder: Schimmer, Jürgen, 90473 Nürnberg (DE); Bormann, Ulf, 90518 Altdorf (DE); Meyer, Martin, 90425 Nürnberg (DE); Scheibner, Dirk, 90473 Nürnberg (DE)

(57) **Zusammenfassung**

Die Erfindung betrifft ein Verfahren zur Bereitstellung einer Phaseninformation eines Versorgungsnetzes (6). Um eine zentrale Bereitstellung der Phaseninformation zu ermöglichen, wird vorgeschlagen, dass die Phaseninformation durch Detektion zumindest eines Nulldurchgangs zumindest einer Phase (L1, L2, L3) des Versorgungsnetzes (6) ermittelt wird, wobei ein digitales Datenpaket mit zumindest der Phaseninformation und einer mit der Phaseninformation korrespondierenden Zeitinformation erzeugt wird und wobei das Datenpaket über eine Kommunikationsschnittstelle (36) versendet wird.

## Beschreibung

Die Erfindung betrifft ein Verfahren zur Bereitstellung einer Phaseninformation eines Versorgungsnetzes.

Ferner betrifft die Erfindung eine Vorrichtung zur Bereitstellung einer Phaseninformation eines Versorgungsnetzes.

Darüber hinaus betrifft die Erfindung ein System mit zumindest einer derartigen Vorrichtung.

Bei Messungen an einem Versorgungsnetz und an direkt am Versorgungsnetz angeschlossenen Verbrauchern sind eine direkte Kenntnis einer Netzphase, respektive eines Phasennulldurchgangs erforderlich. Beispielsweise wird die Phaseninformation für Strom- und Energie-Messvorrichtungen zur Unterscheidung eines Blind- und eines Wirkanteils aber auch zur Ermittlung einer Stromrichtung benötigt. Darüber hinaus wird die Phaseninformation bei Schützen und anderen Schalteinrichtungen benutzt, um einen Verbraucher zu einem günstigen Zeitpunkt innerhalb einer Netzperiode zuzuschalten. Eine überwiegend induktive Last wie ein Motor wird beispielsweise in einem Maximum einer Spannung geschaltet, während eine überwiegend resistive Last wie eine Heizung in einem Nulldurchgang einer Spannung geschaltet wird. Überwiegend kapazitive Lasten, wie Kompensationskondensatoren zur Blindleistungskompensation, werden in einem Spannungs-Nulldurchgang zu- und in einem Spannungs-Maximum abgeschaltet. Bei Sensoranwendungen, wie beispielsweise bei einer Teilentladungsmesstechnik, welche insbesondere bei Hochspannungsmotoren verwendet wird, ist eine Phaseninformation ebenfalls erforderlich, da ein Bezug eines Teilentladungsimpulses zur Netzphase Informationen zu einem Ort und zu einer Charakteristik der Teilentladungsquelle liefert.

Die Offenlegungsschrift EP 2073342 A1 beschreibt ein Verfahren und eine Vorrichtung zur Ermittlung der elektrischen Wirkleistung von Verbraucherabzweigen, wobei die Wirkleistung ausgehend von erfassten Strom- und Spannungswerten sowie einer zugehörigen synchronisierten Zeitinformation ermittelt wird.

Der Erfindung liegt die Aufgabe zugrunde, ein Verfahren anzugeben, welches eine zentrale Bereitstellung einer Phaseninformation eines Versorgungsnetzes ermöglicht.

Diese Aufgabe wird erfindungsgemäß durch ein Verfahren zur Bereitstellung einer Phaseninformation eines Versorgungsnetzes gelöst, wobei die Phaseninformation durch Detektion zumindest eines Nulldurchgangs zumindest einer Phase des Versorgungsnetzes ermittelt wird, wobei ein digitales Datenpaket mit zumindest der Phaseninformation und einer mit der Phaseninformation korrespondierenden Zeitinformation erzeugt wird und wobei das Datenpaket über eine Kommunikationsschnittstelle versendet wird.

Ferner wird die Aufgabe erfindungsgemäß durch eine Vorrichtung zur Bereitstellung einer Phaseninformation eines Versorgungsnetzes gelöst, welche mindestens eine Detektionsvorrichtung zur Detektion zumindest eines Nulldurchgangs zumindest einer Phase des Versorgungsnetzes, Mittel zur Bereitstellung einer mit der Phaseninformation korrespondierenden Zeitinformation, Mittel zur Erstellung eines digitalen Datenpakets aus der Phaseninformation und der korrespondierenden Zeitinformation und eine Kommunikationsschnittstelle zur Bereitstellung des Datenpakets aufweist.

Darüber hinaus wird die Aufgabe erfindungsgemäß durch ein System mit zumindest einer derartigen Vorrichtung und zumindest einem mit der Vorrichtung zeitlich synchronisierten Client, welcher ein Telegramm der Vorrichtung nutzt, gelöst. Die in Bezug auf das Verfahren nachstehend angeführten Vorteile und bevorzugten Ausgestaltungen lassen sich sinngemäß auf die Vorrichtung und das System übertragen.

Der Erfindung liegt die Überlegung zugrunde, eine Phaseninformation eines Versorgungsnetzes durch Ermittlung zumindest eines Nulldurchgangs, insbesondere eines Spannungs-Nulldurchgangs, zumindest einer Phase des Versorgungsnetzes zusammen mit einer korrespondierenden Zeitinformation zentral bereitzustellen. Eine zentrale Bereitstellung der Phaseninformation bedeutet, dass die Phaseninformation mit Hilfe einer zentral angeordneten Vorrichtung ermittelt und von dort aus an mehrere Teilnehmer, sogenannte Clients, gesendet wird. Die zumindest eine Phase mit der korrespondierenden Zeitinformation wird in einem Datenpaket über eine Kommunikationsschnittstelle, beispielsweise über Bluetooth oder WLAN, versendet. Das Datenpaket enthält zumindest die Phaseninformation und die korrespondierende Zeitinformation. Durch die zentrale Bereitstellung der Phaseninformation des Versorgungsnetzes ergibt sich, insbesondere im Vergleich zu einzelnen Phasendetektoren, eine vereinfachte und kostengünstigere Systemarchitektur. Neben dem Hardwareaufwand des Systems wird der Installationsaufwand reduziert. Aufgrund der Zeitsynchronisation ist die Auswertung des Datenpakets für den Nulldurchgang unabhängig von einer Kommunikationslast und einer Laufzeit im Kommunikationsnetz.

Der Nulldurchgang wird mit einer Detektionsvorrichtung ermittelt, welche ein Netzsignal und/oder ein Signal, das das Netzsignal repräsentiert, abgreift und auswertet. Ein Signal, das das Netzsignal repräsentiert, ist insbesondere ein synchron zur Netzfrequenz moduliertes Signal, beispielsweise ein Flackern einer Beleuchtung, welche mit dem Netzsignal betrieben wird. Die Mittel zur Bereitstellung einer mit der Phaseninformation korrespondierenden Zeitinformation umfassen beispielsweise einen Zeit-Server, der eine präzise Zeit aus einem extern zugeführten Signal gewinnt. Die Mittel zur Erstellung eines digitalen Datenpakets aus der Phaseninformation und der korrespondierenden Zeitinformation umfassen beispielsweise einen Mikrocontroller oder einen anderen programmierbaren Logikbaustein, sodass eine Leistungsaufnahme der Vorrichtung minimiert wird. Ferner wird durch die digitale Signalverarbeitung eine Integration zusätzlicher Funktionalitäten zumindest vereinfacht.

In einer vorteilhaften Ausführungsform basiert die Detektion auf einer Vergleichsoperation. Beispielsweise wird mittels eines Phasenkomparators ein detektiertes Signal mit zumindest einem Referenzsignal verglichen. Eine derartige Vergleichsoperation ist einfach und kostengünstig zu realisieren.

Bei einer bevorzugten Ausgestaltung wird die Vergleichsoperation in einer mitlaufenden Regelung durchgeführt. Eine mitlaufende Regelung ist beispielsweise eine Phased-Locked-Loop, kurz PLL. Durch die mitlaufende Regelung wird eine Störsicherheit bei der Ermittlung des Nulldurchgangs erhöht.

Besonders vorteilhaft wird die Zeitinformation über einen Zeit-Netzwerkdienst bereitgestellt. Zeit-Netzwerkdienste sind beispielsweise NTP (Network Time Protokoll) oder PTP (Precision Time Protocol). Bei der Nutzung eines Zeit-Netzwerkdienstes wird eine hohe Genauigkeit gewährleistet.

Bei einer weiteren vorteilhaften Ausführungsform wird die Zeitinformation aus einem Global Navigation Satellite System-Signal, kurz GNSS-Signal, ermittelt. Ein GNSS-Signal ist beispielsweise ein GPS- oder ein Galileo-Signal. Die Ermittlung einer Zeitinformation aus einem GNSS-Signal ist einfach und kostengünstig. Ferner ist die Bereitstellung einer zusätzlichen Zeitserver-Funktionalität möglich.

Bei einer bevorzugten Ausgestaltung ist das Datenpaket als Telegramm ausgeführt und wird über eine Netzwerkschnittstelle versendet. Die Netzwerkschnittstelle ist beispielsweise für kabellose und/oder kabelgebundene Netzwerkverbindungen geeignet. Beispielsweise wird eine Ethernet-Schnittstelle oder eine andere standardisierte Netzwerkschnittstelle verwendet. Durch ein Telegramm, welches über eine Netzwerkschnittstelle versendet wird, wird eine hohe Zuverlässigkeit hinsichtlich der zeitlichen Synchronisation und der Störanfälligkeit der Kommunikationsverbindung erreicht.

Bei einer weiteren vorteilhaften Ausführungsform enthält das Datenpaket zumindest eine Zusatzinformation. Eine Zusatzinformation ist beispielsweise eine Quelle der Zeitsynchronisation, eine Netzfrequenz und/oder eine Genauigkeit der Phaseninformation. Durch derartige Zusatzinformationen wird eine Fehlererkennung erleichtert. Durch eine verbesserte Fehlererkennung werden die Zuverlässigkeit und die Verfügbarkeit erhöht.

Im Folgenden wird die Erfindung anhand der in den Figuren dargestellten Ausführungsbeispiele näher beschrieben und erläutert.

Es zeigen:
- FIG 1: ein Blockschaltbild eines Systems mit einem Zero-Crossing-Server,
- FIG 2: ein Blockschaltbild eines Zero-Crossing-Servers und
- FIG 3: ein Blockschaltbild einer Vorrichtung zur Detektion einer Phaseninformation mit einer mitlaufenden Regelung.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

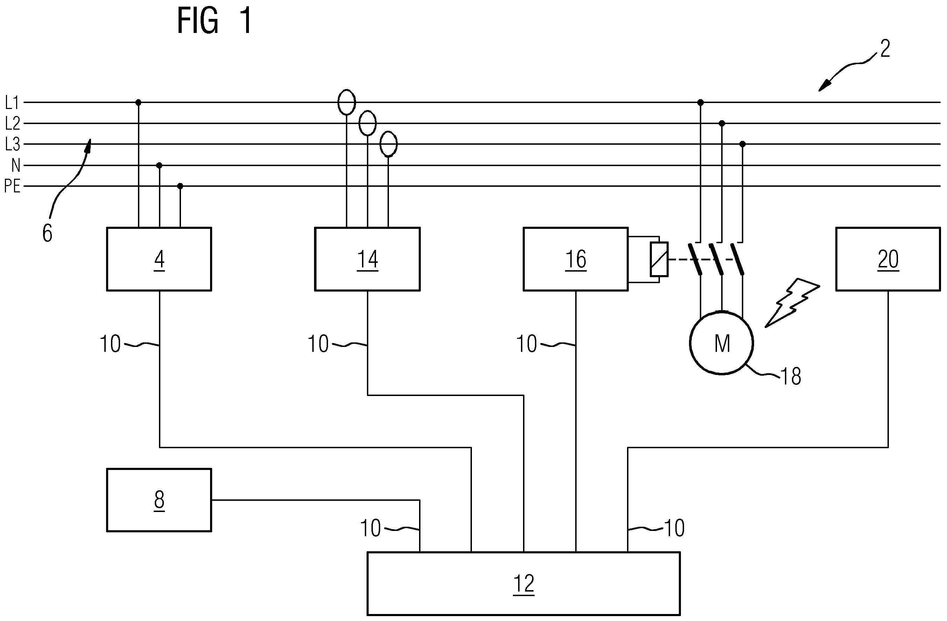

FIG 1 zeigt ein Blockschaltbild eines Systems 2 mit einem Zero-Crossing-Server 4. Der Zero-Crossing-Server 4 ist eine Vorrichtung, welche im System 2 zentral eine Phaseninformation zu mindestens einer Phase L1, L2, L3 eines, beispielsweise dreiphasigen, Versorgungsnetzes 6 bereitstellt. Aus der Phaseninformation ergibt sich unmittelbar eine Nulldurchgangsinformation, also ein Zeitpunkt, an dem die mindestens eine, insbesondere sinusförmige, Phase L1, L2, L3 den Wert Null annimmt. Beispielsweise wird ein Spannungs-Nulldurchgang ermittelt. Die Phaseninformation wird mit einer korrespondierenden Zeitinformation, welche von einem Zeit-Server 8 bereitgestellt wird, zu einem digitalen Datenpaket, welches als für eine Netzwerkverbindung geeignetes Telegramm ausgeführt ist, verarbeitet und über eine Netzwerkverbindung 10 an eine Netzwerkweiche 12, auch Switch genannt, gesendet. Der Zeit-Server 8 gewinnt seine eigene präzise Zeit aus einem GNSS-Signal. Alternativ wird das präzise Zeitsignal von einer Atomuhr oder von einem anderen Zeitserver, beispielsweise über das Internet, gewonnen.

Optional ist der Zeitserver 8 zumindest teilweise im Zero-Crossing-Server 4 angeordnet, sodass durch den Zero-Crossing-Server 4 zusätzlich eine Zeitserver-Funktionalität zur Verfügung gestellt werden kann. Die Netzwerkverbindung wird beispielsweise über ein kabelgebundenes Datennetz, beispielsweise über Ethernet, über Lichtleiter oder kabellos, beispielsweise über WLAN hergestellt. Geeignete Protokolle sind beispielsweise UDP Broadcast oder OPC UA. Aufgrund der Zeitsynchronisation des Clients ist die Auswertung des Telegramms unabhängig von einer Netzwerklast und einer Laufzeit im Netzwerk.

Über die Netzwerkweiche 12 wird das Telegramm vom Zero-Crossing-Server 4, welches die Phaseninformation mit einer korrespondierenden Zeitinformation enthält, exemplarisch an mehrere Teilnehmer, sogenannte Clients, übertragen. Clients sind in FIG 1 exemplarisch eine Strom- und/oder Leistungs-Messvorrichtung 14, eine Schaltvorrichtung 16 für eine elektrische rotierende Maschine 18 und eine Sensorvorrichtung 20. Die Phaseninformation wird von der Strom- und Energie-Messvorrichtung 14 dazu benötigt, Blind- und Wirkanteil zu unterscheiden und/oder eine Stromrichtung zu erkennen. Die Schaltvorrichtung 16 verwendet die Phaseninformation beispielsweise, um die elektrische rotierende Maschine 18 zu einem günstigen Zeitpunkt innerhalb einer Netzperiode mit dem Versorgungsnetz 6 zu verbinden. Da die elektrische rotierende Maschine 18 eine überwiegend induktive Last darstellt, wird diese bei einem Spannungsmaximum geschaltet. Eine überwiegend resistive Last, wie beispielsweise eine Heizung, wird in einem Spannungsnulldurchgang geschaltet und eine überwiegend kapazitive Last, wie beispielsweise ein Kondensator zur Blindleistungskompensation, wird in einem Spannungsnulldurchgang zugeschaltet und bei einem Spannungsmaximum ausgeschaltet. Die Sensorvorrichtung 20 ist beispielsweise als eine Teilentladungs-Messvorrichtung für eine Hochspannungsmaschine ausgestaltet, wobei ein Bezug eines Teilentladungsimpulses zur Netzphase Informationen zu einem Ort und zu einer Charakteristik der Teilentladungsquelle liefert. Zur Darstellung werden beispielsweise sogenannte PRPD(Phase Resolved Partial Discharge)-Plots verwendet.

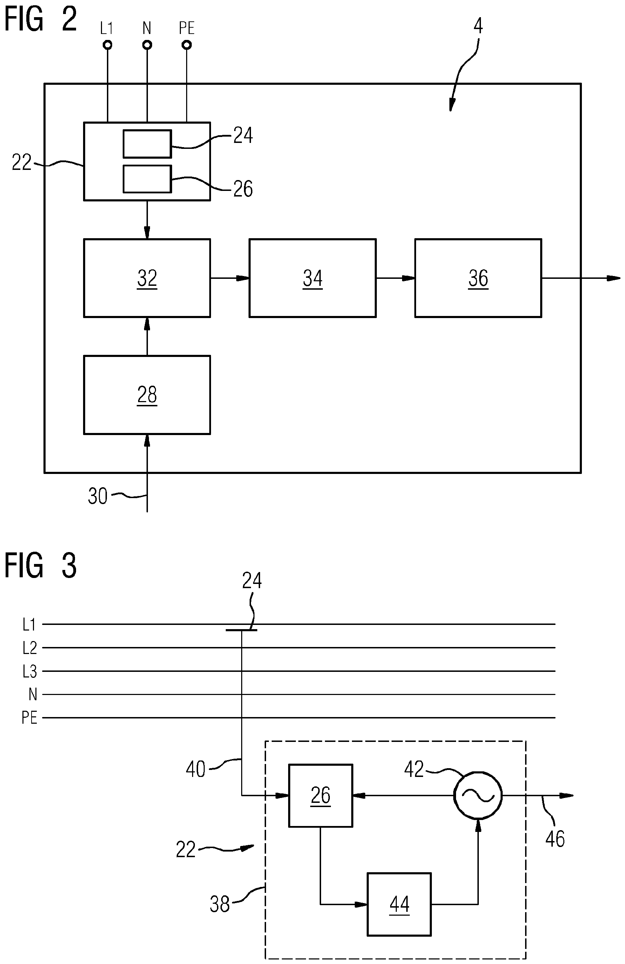

FIG 2 zeigt ein Blockschaltbild eines Zero-Crossing-Servers 4. Der Zero-Crossing-Server 4 ist beispielhaft mit einer Phase L1 eines Versorgungsnetzes 6 verbindbar und weist mindestens eine Vorrichtung 22 zur Detektion einer Phaseninformation mittels eines Detektionsalgorithmus für Nulldurchgänge auf. Die Detektionsvorrichtung 22 umfasst mindestens ein elektronisches Bauelement 24 zur Detektion zumindest eines Nulldurchgangs zumindest dieser Phase. Beispielsweise wird ein kapazitiver oder resistiver Spannungsteiler verwendet, dessen Ausgangssignal proportional zur Phase L1 des Versorgungsnetzes 6 ist, wobei das Ausgangssignal des kapazitiven Spannungsteilers optional digitalisiert wird. Ferner umfasst die Detektionsvorrichtung 22 zumindest einen Phasenkomparator 26. Der Phasenkomparator 26 ist als ein analoges oder digitales elektronisches Bauteil ausgeführt. Alternativ ist der zumindest eine Phasenkomparator 26 einem Mikrocontroller oder einem anderen programmierbaren Logikbaustein zugeordnet. Mit Hilfe des Phasenkomparators 26 wird zur Ermittlung der Phaseninformation beispielsweise eine Vergleichsoperation mit einem Referenzsignal durchgeführt. Eine Mehrzahl von parallel betriebenen Phasenkomparatoren 26 ermöglicht eine Beschleunigung des Verfahrens.

Der Zero-Crossing-Server 4 weist darüber hinaus Mittel 28 zur Bereitstellung einer mit der Phaseninformation korrespondierenden Zeitinformation auf, welche eine Zeitinformations-Schnittstelle 30 zu einem Zeit-Netzwerkdienst und/oder einem Zeit-Server 8 umfassen. Als Zeit-Netzwerkdienst wird beispielsweise NTP oder PTP verwendet. Der Zeit-Netzwerkdienst und/oder der Zeit-Server 8 sind aus Gründen der Übersichtlichkeit nicht in FIG 2 dargestellt. Über eine Zeitserver-Funktionalität wird optional eine globale Systemzeit für eine Zeitsynchronisation zur Verfügung gestellt.

Ferner umfasst der Zero-Crossing-Server 4 Auswertungselektronik 32 zur Bestimmung der Nulldurchgangszeitpunkte bezogen auf die bereitgestellte Zeitinformation. Die Auswerteelektronik 32 ist, beispielsweise zusammen mit zumindest einem Phasenkomparator 26, auf einem Mikrocontroller oder einen anderen programmierbaren Logikbaustein integriert. Beispielsweise wird der jeweiligen Phaseninformation, welche sich unmittelbar aus den Nulldurchgängen ergibt, mit Hilfe digitaler Signalverarbeitung eine korrespondierende Zeitinformation zugeordnet.

Mit Hilfe von Mitteln 34 zur Erstellung eines Datenpakets wird aus der Phaseninformation und der korrespondierenden Zeitinformation ein digitales Datenpaket erzeugt. Exemplarisch wird ein Telegramm erzeugt, welches für das Versenden über eine Netzwerkverbindung, beispielsweise Ethernet, geeignet ist. Die Mittel 34 zur Telegrammerstellung umfassen eine Elektronik, die beispielsweise ebenfalls auf einem Mikrocontroller oder einen anderen programmierbaren Logikbaustein integriert ist. Das Telegramm wird über eine Kommunikationsschnittstelle 36, welche exemplarisch als Netzwerkschnittstelle ausgeführt ist, versendet. Die Kommunikationsschnittstelle 36 ist beispielsweise kabelgebunden, insbesondere als Ethernet-Schnittstelle, oder kabellos, insbesondere als WLAN-Schnittstelle ausgeführt. Alternativ ist eine Verbindung über Lichtleiter herstellbar. Optional werden über das Telegramm Zusatzinformationen, wie beispielsweise eine Quelle der Zeitsynchronisation, eine Netzfrequenz und/oder eine Genauigkeit der Phaseninformation, übertragen. Die weitere Ausgestaltung des Zero-Crossing-Servers 4 in FIG 2 entspricht der in FIG 1.

FIG 3 zeigt ein Blockschaltbild einer Vorrichtung 22 zur Detektion einer Phaseninformation mit einer mitlaufenden Regelung 38. Die Detektionsvorrichtung 22 umfasst ein elektronisches Bauelement 24, das beispielhaft als kapazitiver Sensor ausgeführt ist. Das Sensorsignal 40 des kapazitiven Sensors wird an die mitlaufende Regelung 38, welche als Phased-Locked-Loop, kurz PLL, ausgeführt ist, weitergeleitet. Die PLL umfasst weiterhin einen Phasenkomparator 36, einen, insbesondere über eine Spannung, in seiner Frequenz steuerbaren Oszillator 42 und ein Schleifenfilter 44. Das Ausgangssignal 46 der Detektionsvorrichtung 22 wird, wie in FIG 2 gezeigt, an eine Auswertungselektronik 32 weitergeleitet. Die weitere Ausgestaltung der Vorrichtung 22 zur Detektion einer Phaseninformation in FIG 3 entspricht der in FIG 2.

Zusammenfassend betrifft die Erfindung ein Verfahren zur Bereitstellung einer Phaseninformation eines Versorgungsnetzes 6. Um eine zentrale Bereitstellung der Phaseninformation zu ermöglichen, wird vorgeschlagen, dass die Phaseninformation durch Detektion zumindest eines Nulldurchgangs zumindest einer Phase L1, L2, L3 des Versorgungsnetzes 6 ermittelt wird, wobei ein digitales Datenpaket mit zumindest der Phaseninformation und einer mit der Phaseninformation korrespondierenden Zeitinformation erzeugt wird und wobei das Datenpaket über eine Kommunikationsschnittstelle 36 versendet wird.

## Patentansprüche

1. Verfahren zur Bereitstellung einer Phaseninformation eines Versorgungsnetzes (6),
wobei die Phaseninformation durch Detektion zumindest eines Nulldurchgangs zumindest einer Phase (L1, L2, L3) des Versorgungsnetzes (6) ermittelt wird,
wobei ein digitales Datenpaket mit zumindest der Phaseninformation und einer mit der Phaseninformation korrespondierenden Zeitinformation erzeugt wird,
wobei das Datenpaket über eine Kommunikationsschnittstelle (36) versendet wird.

2. Verfahren nach Anspruch 1,
die Detektion auf einer Vergleichsoperation basiert.

3. Verfahren nach Anspruch 2,
wobei die Vergleichsoperation in einer mitlaufenden Regelung durchgeführt wird.

4. Verfahren nach einem der vorherigen Ansprüche,
wobei die Zeitinformation über einen Zeit-Netzwerkdienst bereitgestellt wird.

5. Verfahren nach einem der vorherigen Ansprüche,
wobei die Zeitinformation aus einem GNSS-Signal ermittelt wird.

6. Verfahren nach einem der vorherigen Ansprüche,
wobei das Datenpaket als Telegramm ausgeführt ist und über eine Netzwerkschnittstelle versendet wird.

7. Verfahren nach einem der vorherigen Ansprüche,
wobei das Datenpaket zumindest eine Zusatzinformation enthält.

8. Vorrichtung (4) zur Bereitstellung einer Phaseninformation eines Versorgungsnetzes (6), welche
- mindestens eine Detektionsvorrichtung (22) zur Detektion zumindest eines Nulldurchgangs zumindest einer Phase (L1, L2, L3) des Versorgungsnetzes (6),
- Mittel (28) zur Bereitstellung einer mit der Phaseninformation korrespondierenden Zeitinformation,
- Mittel (34) zur Erstellung eines digitalen Datenpakets aus der Phaseninformation und der korrespondierenden Zeitinformation und
- eine Kommunikationsschnittstelle (36) zur Bereitstellung des Datenpakets aufweist.

9. Vorrichtung (4) nach Anspruch 8,
wobei die mindestens eine Detektionsvorrichtung (22) zumindest einen Phasenkomparator (26) umfasst.

10. Vorrichtung (4) nach einem der Ansprüche 8 oder 9,
wobei die mindestens eine Detektionsvorrichtung (22) zumindest eine mitlaufende Regelung (38) umfasst.

11. Vorrichtung (4) nach einem der Ansprüche 8 bis 10,
wobei die Mittel (28) zur Bereitstellung einer mit der Phaseninformation korrespondierenden Zeitinformation eine Zeitinformations-Schnittstelle (30) zu einem Zeit-Netzwerkdienst umfassen.

12. Vorrichtung (4) nach einem der Ansprüche 8 bis 11,
wobei das Datenpaket als Telegramm und die Kommunikationsschnittstelle (36) als Netzwerkschnittstelle ausgeführt sind.

13. System (2) mit zumindest einer Vorrichtung (4) nach einem der Ansprüche 7 bis 12 und zumindest einem mit der Vorrichtung (4) zeitlich synchronisierten Client, welcher ein Telegramm der Vorrichtung (4) nutzt.
